# EUROPEAN PATENT APPLICATION

(11) **EP 2 722 932 A1**
(43) Date of publication of application: **23.04.2014**
(21) Application number: 12007205.3
(22) Date of filing: 18.10.2012
(51) Int. Cl.: H01R 4/66, H02G 3/06, G01R 1/04, G01R 3/00

(54) **Ground connection for a casted measurement device housing**

(71) Applicant: ABB Technology AG, 8050 Zürich (CH)
(72) Inventor: Raschka, David, 664 91 Ivancice (CZ); Podzemmy, Jaromir, 621 00 Brno (CZ); Velesik, Petr, 602 00 Brno (CZ)
(74) Representative: Schmidt, Karl Michael

(57) **Abstract**

The invention relates to a casted housing of a measurement device comprising a voltage and/or a current sensor. The sensor component is connected, by a signal wire, to an externally ending output connector, and, by a grounding wire, to a grounding output connector. The signal connector output and the grounding connector output result in an electrical connecting terminal. In order to ensure an accurate positioning of the voltage and/or current measurement device during the moulding process, as well as to ensure the mechanical and electrical fixation of the connecting terminal at the measurement device, a further mechanical element (8) is arranged, at the electrical connecting terminal, and provided with a central hole (10), through which the signal connector output is fed. The mechanical element (8) is also provided with at least one further connecting finger (8'), which is used as electrical grounding connection as well as a mechanical fixation of the electrical connecting terminal during the moulding process.

## Description

The invention relates to a measurement device in which voltage and/or a current sensor in a casted measurement device housing, wherein the sensor component is connected with a externally ending output connector by a signal wire, and with a grounding wire to a grounding output connector, where signal connector output and grounding connector output results as the electrical connecting terminal, according to the preamble of claim 1.

The traditional approach of a measurement device connector holder relies on a special fixation component to ensure the connector placement in the defined position during manufacturing process. Such special fixation component is a part of the casting mould or it is removeable after manufacturing process. In both cases it has no job within the measurement device functionality after the manufacturing process.
From the measurement device grounding system point of view, the appropriate interconnection between active internal parts point(s) which must be grounded and the earth potential is performed by a separate conductor connected to a sensing component on the one side and, on the oposite side, for example to an additional metal insert which is afterwards grounded.

It is an object of the invention to ensure an accurate positioning of the voltage and/or current measurement device during the molding process, as well as a sure mechanical and electrical fixation of the connecting terminal at the ready measurement device.

So this is solved by the features of the invention, which are,
that a further mechanical element (8) is arranged at the electrical connecting terminal, and provided with a central hole (10), through which the signal connector output is feeded, and at least one further connecting finger (8'), which is used as electrical
grounding connection as well as a mechanical fixation of the electrical connecting terminal during the moulding process.

So, during the molding process, the invention related mechanical element ensures an accurate positioning of the connecting signal terminal. Additionally to that this element has the implemented function of a grounding connector holder as well.

So in order to combine measurement device connector fixation function during manufacturing process and a conductive connection function within the measurement device grounding system during the period when the measurement device is in use, it is proposed to integrate these requirements in a common solution.
This differs from the state of the art, in which mechanical fixation and electrical grounding connection will be handeld by separated elements.

In a further embodiment is proposed, that the mechanical element is provided with a central plate, where the central hole is arranged, and with at least one finger element aligned away from the central plate. So the signal output connector is positioned very accurate during the molding process.

In a further advantageous embodiment at least three finger element are arranged circular and equidistant to each other around the central plate and the central hole.

In a further advantageous embodiment each of the fingers are provided with holes near the end of each fingers.

In a further advantageous embodiment is proposed, that the central hole has a section which differs from a circular cercumferential inner line, in that way, that the mechanical/connecting element is provided with that with an antitwist protection relative to connector.

The invention is shown in the drawing and described as follows.

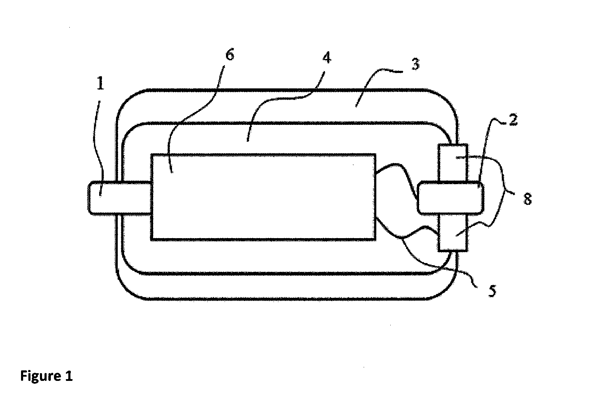

In order to combine measurement device connector fixation function during manufacturing process and a conductive connection function within the measurement device grounding system during the period when the measurement device is in use, it is proposed to integrate these requirements separate solutions, into a single component solution.
Such component 8 will be fixed to the measurement device body 4 and/or to any internal current and/or voltage sensing part 6 and/or to a mould 3 in one or more points on the one side and to the measurement device input and/or output connector 2 in one or more points on the oposite side. Conductive coupling between the connector holder 8 and the current and/or voltage sensing part 6 will be solved either as the direct connection by a conductor 5, see Fig. 1, or by a dedicated section of the grounding connector holder 8 connected to the voltage and/or current sensing element 6, or as an indirect connection when connector holder 8 will be conductively coupled with the connector 2 which will be conductively coupled with the sensing part 6.
Material of the component 8 must be selected in such a way to ensure the providing both mechanical stability of the measurement device connector 2 placement during manufacturing process and during the measurement device 4 operational time - mechanical deformation of any section of the connector holder 8 due to a mechanical load as a result of the holder 8 fixation and the connector 2 weight must be less than 10mm in any axes direction - and electrical properties to ensure sufficient electrical charge transfer within its functionality as a part of the measurement device grounding system.
The advantage of the proposed solution is the combination of mechanical and electrical functionality within one single part, what means less complete assembly components, easirer manufacturing process, reduced manufacturing time and reduced production costs of the final measurement device.
Additional advantage of the proposed solution is the reinforcing effect of the grounding holder 8 of the connector 2 to the measurement device body 4 structure.

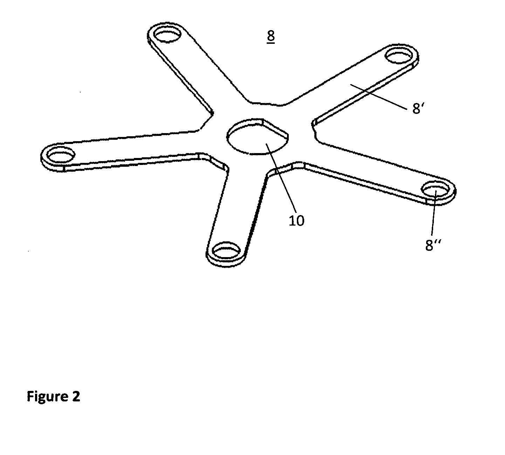

Figure 2 shows the grounding connector holder 8 in detail. This embodiment of the groud connector holder 8 shows the central hole 10, through is feeded the signal connectors 2 shown in figure 1. Furthermore is shown in figure 2, that this hole is not perfect round, but has a section which differs from a perfect round inner line, in order to correspond mechanically with a complementive outer surface of the connector in such a way, that with this is implemented an antitwist element.
Furthermore the grounding connector holder 8 has five fingerelements 8' whoich are arrangned circular around the inner plate section of the holder 8. These fingers has holes 8" at each their ends for mechanical and/or electrical connection to ground potential.

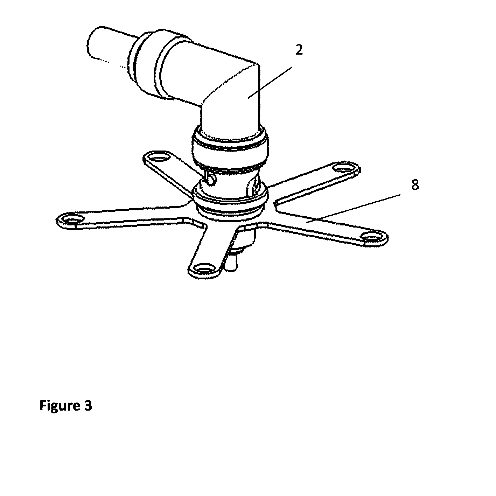

Figure 3 shows the grounding connector 8 in connection with the signal connector 2.

### Position numbers

- 1: Fixation component
- 2: Signal input and/or output connector
- 3: Mould
- 4: Measurement device body
- 5: Conductor
- 6: Sensing part/sensor
- 8: grounding connector holder
- 8': finger element
- 8": hole in finger element
- 10: central hole

## Claims

1. Measurement device in which voltage and/or a current sensor in a casted measurement device housing, wherein the sensor component is connected with a externally ending output connector by a signal wire, and with a grounding wire to a grounding output connector, where signal connector output and grounding connector output results as the electrical connecting terminal,
**characterized in**
**that** a further mechanical element (8) is arranged at the electrical connecting terminal, and provided with a central hole (10), through which the signal connector output is feeded, and at least one further connecting finger (8'), which is used as electrical grounding connection as well as a mechanical fixation of the electrical connecting terminal during the moulding process.

2. Measurement device according to claim 1,
**characterized in**
**that** the mechanical element (8) is provided with a central plate, where the central hole is arranged, and with at least one finger element (8') aligned away from the central plate.

3. Measurement device according to claim 1 or 2,
**characterized in**
**that** at least three finger element (8') are arranged circular and equidistant to each other around the central plate and the central hole (10).

4. Measurement device according to claim 1, or 2, or3,
**characterized in**
**that** each of the fingers (8') are provided with holes (8") near the end of each fingers (8').

5. Measurement device according to one of the aforesaid claims,
**characterized in**
**that** the central hole has a section which differs from a circular cercumferential inner line, in that way, that the mechanical/connecting element (8) is provided with that with an antitwist protection relative to connector (2).
